# EUROPEAN PATENT SPECIFICATION

(11) **EP 2 395 132 B1**
(45) Date of publication and mention of the grant of the patent: **07.05.2014**
(21) Application number: 11169730.6
(22) Date of filing: 14.06.2011
(51) Int. Cl.: C30B 28/10, C30B 15/00, H01L 31/18

(54) **Method and apparatus for manufacturing silicon substrate with excellent productivity and surface quality using continuous casting**
Verfahren und Vorrichtung zur Herstellung eines Silicium-Substrats mit ausgezeichneter Produktivität und Oberflächenqualität mittels Stranggießverfahren
Procédé et appareil de fabrication de substrat en silicium ayant une excellente productivité et qualité de surface à l'aide d'un moulage continu

(30) Priority: 14.06.2010 KR 20100055948; 10.06.2011 KR 20110056066
(43) Date of publication of application: 14.12.2011
(73) Proprietor: Korea Institute of Energy Research, Daejeon 305-343 (KR)
(72) Inventor: Jang, Bo-Yun, 305-330 Daejeon (KR); Lee, Jin-Seok, 301-080 Daejeon (KR); Ahn, Young-Soo, 305-509 Daejeon (KR)
(74) Representative: Plougmann & Vingtoft A/S

(56) References cited:
- EP-A1- 0 497 148
- WO-A1-2005/104244
- WO-A1-2005/122287
- WO-A1-2011/096815
- DE-A1- 3 419 137
- DE-A1- 10 047 929
- LANGE H ET AL: "RIBBON GROWTH ON SUBSTRATE (RGS) - A NEW APPROACH TO HIGH SPEED GROWTH OF SILICON RIBBONS FOR PHOTOVOLTAICS", JOURNAL OF CRYSTAL GROWTH, ELSEVIER, AMSTERDAM, NL, vol. 104, no. 1, 1 July 1990 (1990-07-01), pages 108-112, XP000138032, ISSN: 0022-0248, DOI: 10.1016/0022-0248(90)90317-E
- KOCH W ET AL: "PREPARATION, CHARACTERISATION AND CELL PROCESSING OF BAYER RGS SILICON FOILS (RIBBON GROWTH ON SUBSTRATE)", 2ND WORLD CONFERENCE ON PHOTOVOLTAIC SOLAR ENERGY CONVERSION. / 15TH EUROPEAN PV SOLAR ENERGY CONFERENCE. / 27TH US IEEE PHOTOVOLTAICS SPECIALISTS CONFERENCE. / 10TH ASIA/PACIFIC PV SCIENCE AND ENGINEERING CONFERENCE. VIENNA, AUSTRIA, JULY 6 - 10, 19, 6 July 1998 (1998-07-06), pages 1254-1259, XP001137936, ISBN: 978-92-828-5419-8
- KALEJS J P: "Silicon ribbons and foils-state of the art", SOLAR ENERGY MATERIALS AND SOLAR CELLS, ELSEVIER SCIENCE PUBLISHERS, AMSTERDAM, NL, vol. 72, no. 1-4, 1 April 2002 (2002-04-01), pages 139-153, XP004339759, ISSN: 0927-0248, DOI: 10.1016/S0927-0248(01)00159-3
- LU J ET AL: "Carrier lifetime limitation defects in polycrystalline silicon ribbons grown on substrate (RGS)", MATERIALS SCIENCE IN SEMICONDUCTOR PROCESSING, ELSEVIER SCIENCE PUBLISHERS B.V., BARKING, UK, vol. 11, no. 1, 1 February 2008 (2008-02-01), pages 20-24, XP025869414, ISSN: 1369-8001, DOI: 10.1016/J.MSSP.2008.07.001 [retrieved on 2008-08-12]
- SPIEGEL M ET AL: "Ribbon growth on substrate (RGS) silicon solar cells with microwave-induced remote hydrogen plasma passivation and efficiencies exceeding 11% - Operating Principles, Technology, and System Applications", SOLAR ENERGY MATERIALS AND SOLAR CELLS, ELSEVIER SCIENCE PUBLISHERS, AMSTERDAM, NL, vol. 55, no. 4, 4 September 1998 (1998-09-04), pages 331-340, XP004153254, ISSN: 0927-0248, DOI: 10.1016/S0927-0248(98)00095-6

## Description

### BACKGROUND

### 1. Technical Field

The present invention relates to a technique for manufacturing a silicon substrate using continuous casting and, more particularly, to a method and apparatus for manufacturing a silicon substrate with excellent productivity and surface quality using continuous casting.

### 2. Description of the Related Art

A silicon substrate is a main component of a silicon solar cell and constitutes about 28% of the price of a solar cell module.

Generally, a silicon substrate for solar cells is manufactured by melting raw silicon and solidifying molten silicon to prepare a single crystalline silicon ingot or polycrystalline silicon block, which in turn is subjected to several cutting processes.

In conventional methods of manufacturing a silicon substrate, about 40~50% of the raw silicon is removed as Kerf-loss through the cutting processes, causing an increase in manufacturing costs.

To prevent Kerf-loss, a technique of directly manufacturing a silicon substrate from molten silicon has been developed.

Currently, a technique for directly manufacturing a silicon substrate from molten silicon can be classified into a vertical growth type and a horizontal growth type. The vertical growth technique has already been used in the art but has a problem of low growth speed. On the other hand, the horizontal growth technique is not used in the art, despite high growth speed.

As the horizontal growth type technique for directly manufacturing a silicon substrate, a ribbon growth on substrate (RGS) process is representatively used. In the RGS process, solidification of molten silicon is controlled in a molten silicon container and shape control is performed using a blade, thereby causing the following problems.

First, in the RGS process, it is necessary to control solidification time to millisecond (msec) precision or less for solidification of the molten silicon within the container. If the solidification time slightly exceeds a preset duration, a solidified substrate is likely to be trapped by a blade, causing a failure of solidification equipment.

Further, uniform solidification is obtained by uniform adjustment of the temperature of the molten silicon over the whole of the substrate. However, it is very difficult to obtain uniform control of the molten silicon having high fluidity.

Further, the RGS process employs the blade for shape control of the substrate. In this case, there is a high possibility of blade failure and mechanical contact between the blade and the silicon substrate is likely to cause contamination of the substrate.

As such, such conventional methods of directly manufacturing a silicon substrate compromise productivity of the silicon substrate and energy conversion efficiency. Therefore, there is a need for a method for manufacturing a silicon substrate for solar cells, which can improve both productivity and quality of the silicon substrate.

WO 2005/104244 A1 discloses for example an apparatus suitable for manufacturing a silicon substrate by continuous casting.

### BRIEF SUMMARY

One aspect of the invention is to provide an apparatus for manufacturing a silicon substrate for solar cells, which can directly manufacture a silicon substrate with improved surface quality from molten silicon through continuous casting that facilitates continuous production and property control of the silicon substrate.

Another aspect of the invention is to provide a silicon substrate manufacturing method which can directly manufacture a silicon substrate from molten silicon using continuous casting to reduce Kerf-loss.

In accordance with one embodiment, there is provided an apparatus for manufacturing a silicon substrate using continuous casting which provides excellent productivity and excellent surface quality. The apparatus includes a raw silicon feeder through which raw silicon is fed; a silicon melting unit disposed under the raw silicon feeder and melting the raw silicon to form molten silicon; a molten silicon storage unit storing the molten silicon supplied from the silicon melting unit and tapping the molten silicon to provide a silicon melt having a constant thickness; a transfer board disposed at one side of the molten silicon storage unit and transferring the tapped silicon melt; and a silicon substrate forming unit cooling the silicon melt transferred by the transfer board to form a silicon substrate.

The silicon melting unit (120) comprises a crucible (121) for receiving the raw silicon supplied from the raw silicon feeder (110) and having a tapping hole (123) formed at a lower side thereof, an induction coil (122) wound around an outer wall of the crucible (121), and a gate (124) opening or closing the tapping hole (123). and

The crucible (121) is a graphite crucible including a plurality of first slits (230) longitudinally formed on a part of a wall of the crucible or a plurality of second slits (310) longitudinally formed on a part of a bottom surface of the crucible (121).

Here, the molten silicon stored in the molten silicon storage unit has a surface temperature of 1300~1500°C, the transfer board is preheated to 700~1400°C, and a transfer time of the silicon substrate after tapping the molten silicon from the molten silicon storage unit is 0.5~3.5 seconds.

In accordance with another embodiment, there is provided a method of manufacturing a silicon substrate using continuous casting which provides excellent productivity and excellent surface quality. The method includes: (a) supplying raw silicon into the silicon melting unit; (b) melting the raw silicon placed in the silicon melting unit to form molten silicon; (c) opening a gate of the silicon melting unit to tap the molten silicon; (d) storing the tapped molten silicon in the molten silicon storage unit; (e) driving the transfer board to transfer the molten silicon; (f) cooling the molten silicon transferred by the transfer board to form a silicon substrate; (g) preheating (S410) the transfer board (140) to 700∼1400 °C before supplying the raw silicon into the silicon melting unit (120);
wherein the molten silicon is kept at a surface temperature of 1300-1500 °C in the molten silicon storage unit (120), and
wherein, when driving the transfer board (140) to transfer the molten silicon, the transfer board (140) is moved at a speed of 300~1400 cm/min.

### BRIEF DESCRIPTION OF THE DRAWINGS

The above and other aspects, features, and advantages of the invention will become apparent from the detailed description of the following embodiments in conjunction with the accompanying drawings:
Fig. 1 is a schematic view of an apparatus for manufacturing a silicon substrate using continuous casting according to one exemplary embodiment of the present invention;
Fig. 2 shows one example of a graphite crucible applicable to the present invention;
Fig. 3 shows another example of a graphite crucible applicable to the present invention;
Fig. 4 is a flowchart of a method of manufacturing a silicon substrate using continuous casting according to one exemplary embodiment of the present invention;
Fig. 5 is a picture showing a surface of a silicon substrate manufactured by the method of Fig. 4;
Fig. 6 is a picture showing a bottom surface of the silicon substrate manufactured by the method of Fig. 4; and
Fig. 7 is a picture showing a polished surface of the silicon substrate of Fig. 5.

### DETAILED DESCRIPTION

Exemplary embodiments of the invention will now be described in detail with reference to the accompanying drawings. It should be understood that the present invention is not limited to the following embodiments and may be embodied in different ways, and that the embodiments are given to provide complete disclosure of the invention and to provide thorough understanding of the invention to those skilled in the art. The scope of the invention is limited only by the accompanying claims and equivalents thereof. Like components will be denoted by like reference numerals throughout the specification.

Next, an apparatus for manufacturing a silicon substrate using continuous casting, which provides excellent productivity and surface properties, according to exemplary embodiments of the invention, and a method of manufacturing a silicon substrate using the same will be described with reference to the accompanying drawings.

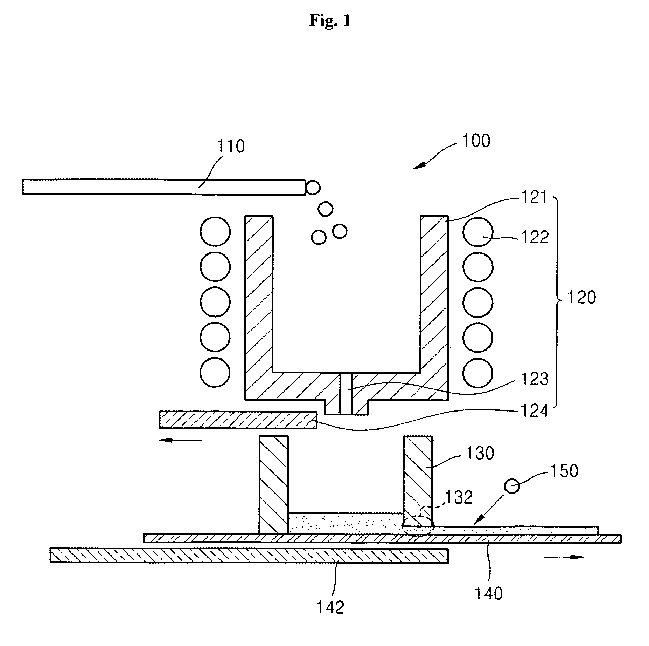

Fig. 1 is a schematic view of an apparatus for manufacturing a silicon substrate using continuous casting according to one exemplary embodiment of the present invention.

Referring to Fig. 1, the apparatus 100 for manufacturing a silicon substrate according to the embodiment includes a raw silicon feeder 110, a silicon melting unit 120, a molten silicon storage unit 130, a transfer board 140, and a silicon substrate forming unit 150.

The raw silicon feeder 110 receives raw silicon from outside and supplies a predetermined amount of raw silicon into the silicon melting unit 120.

The silicon melting unit 120 melts the supplied raw silicon to form molten silicon. The silicon melting unit 120 may melt the raw silicon using various heating manners such as induction heating, resistance heating and the like. Herein, induction heating will be described as an example of a process for melting the raw silicon.

Unlike metal, silicon is difficult to apply direct heating through electromagnetic induction due to low electrical conductivity of silicon at a temperature of about 700°C or less. Thus, raw silicon can be melted through indirect melting in a crucible. For silicon melting through indirect melting, a graphite crucible may be used. Although graphite is non-metallic, excellent electrical and thermal conductivity of graphite facilitate heating of the raw silicon through electromagnetic induction.

Here, when silicon is indirectly melted by heat of the graphite crucible, there is a problem of contamination of silicon or an inner surface of the crucible.

Accordingly, it is desirable that the raw silicon be subjected to indirect melting using crucible heat at a temperature of 700°C or less and subjected to non-contact melting through induction melting at a temperature exceeding 700°C to minimize the problem of contamination of the silicon.

In the case where the raw silicon is melted through induction melting, the silicon melting unit 120 may be an induction melting device that includes a crucible 121, an induction coil 122, a tapping hole 123, and a gate 124.

The crucible 121 receives the raw silicon from the feeder and has the tapping hole 123 formed at a lower side thereof. The induction coil 122 is wound around an outer wall of the crucible 121. The induction coil 122 is connected to an AC power source. The gate 124 opens or closes the tapping hole 123 formed at the lower side of the crucible 121. The gate 124 may be a bar type gate, but is not limited thereto. Alternatively, the gate 124 may be a valve type gate.

To apply silicon induction melting, a water-cooled crucible may be used. However, the water-cooled crucible suffers large heat loss, causing low melting efficiency.

Thus, in this invention, the crucible 121 may be configured to allow induction melting of silicon while improving melting efficiency.

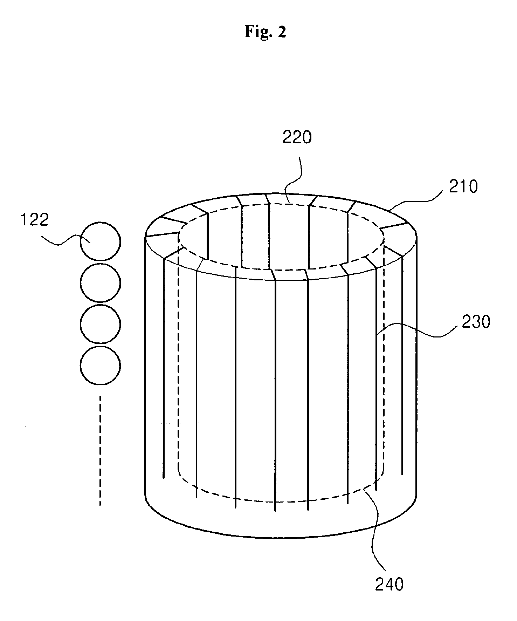

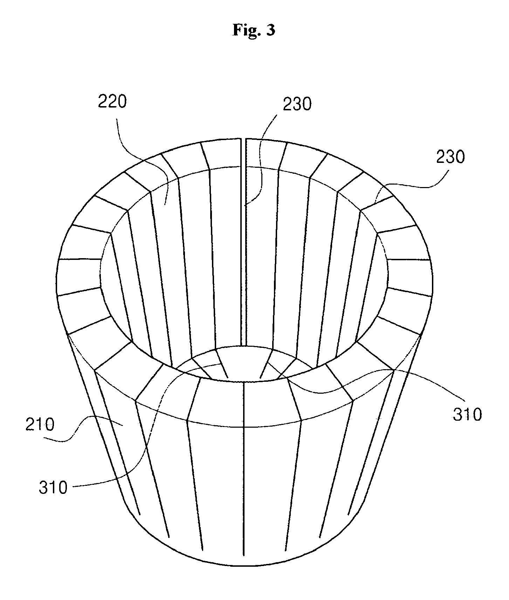

Thus, according to this invention, a graphite crucible having longitudinal slits is used, as shown in Figs. 2 and 3.

Fig. 2 shows one example of the graphite crucible applicable to the present invention.

Referring to Fig. 2, the graphite crucible may have a cylindrical structure in which a plurality of slits 230 is formed to penetrate an outer wall 210 and an inner wall 220. It should be understood that the graphite crucible is not limited thereto and can be modified into various shapes.

In Fig. 2, the graphite crucible is formed with a plurality of longitudinal slits 230, unlike typical graphite crucibles. For the typical graphite crucible, when AC power is applied to the induction coil 122, electromagnetic waves are blocked by graphite so that electromagnetic force is hardly imparted to the crucible.

However, for the graphite crucible having the longitudinal slits 230, it was ascertained through experimentation that the electromagnetic waves were not blocked by graphite and electromagnetic force was intensively imparted towards the internal center of the crucible. As a result, the raw silicon is melted to form molten silicon through induction melting without contacting the inner wall of the crucible by the electromagnetic force imparted towards the internal center of the crucible.

The plurality of longitudinal slits 230 may be formed from an upper side of the crucible near to an inner bottom surface 240 thereof. Further, the plurality of slits 230 are symmetrically formed around the crucible.

Fig. 3 shows another example of the graphite crucible applicable to the present invention.

The crucible shown in Fig. 3 is a graphite crucible which includes a plurality of longitudinal slits 310 formed from an edge of the inner bottom surface 240 of the crucible towards the center of the crucible in addition to the plurality of longitudinal slits 230 penetrating the outer wall 210 and the inner wall 220 of the crucible shown in Figure 2.

For convenience of description, the plurality of longitudinal slits 230 penetrating the outer wall 210 and the inner wall 220 of the crucible will be referred to as first slits, and the plurality of longitudinal slits 310 formed from an edge of the inner bottom surface 240 of the crucible towards the center of the crucible will be referred to as second slits.

The second slits allow electromagnetic force to be directed upwards by uniformly spreading eddy current on the inner bottom surface 240, when the eddy current is focused downwards from the first slits. The second slits permit induction melting of the raw silicon without contacting the inner wall and the bottom surface of the crucible, thereby minimizing contamination of silicon.

Referring again to Fig. 1, the molten silicon storage unit 130 stores molten metal supplied from the silicon melting unit 120 and taps the molten silicon to provide a silicon melt having a constant thickness. The molten silicon storage unit 130 may be open at a lower side thereof. In this case, the transfer board 40 disposed at the lower side of the molten silicon storage unit 130 defines the lower side of the molten silicon storage unit 130.

Further, the molten silicon storage unit 130 is formed at one side of a lower portion thereof with an ejection port 132 through which the molten silicon is ejected. The thickness of the ejection port 132 may act as a factor determining the thickness of a silicon substrate and may be in the range of about 0.1~2 mm.

Further, a cooling device (not shown) may be located near the ejection port 132. In this case, the silicon melt may be ejected from the molten silicon storage unit 130 in a cooled state or an overcooled state.

The transfer board 140 is disposed at one side of the molten silicon storage unit 130 and continuously transfers the silicon melt ejected from the molten silicon storage unit 130. The transfer board 140 may be pre-heated by a preheating unit 142 to minimize temperature difference between the silicon melt and the transfer board.

The transfer board 140 may be made of a material having a different coefficient of thermal expansion than silicon. As the transfer board 140 has a different coefficient of thermal expansion than silicon, the silicon substrate can be easily separated from the transfer board 140 when manufactured by cooling the silicon melt, and the transfer board 140 can be reused.

The transfer board 140 may be made of metal or ceramic materials. Specifically, the transfer board 140 may be made of at least one material selected from C, SiC, Si₃N₄, graphite, Al₂O₃ and Mo. Specifically, the transfer board 140 may be made of SiC or Si₃N₄.

The silicon substrate forming unit 150 cools the silicon melt to form a silicon substrate.

According to one embodiment, the silicon substrate forming unit 150 cools the silicon melt by blowing an inert gas such as argon, helium, nitrogen, and the like.

Inert gas blowing may assist in removal of the remaining melt which can be formed by rapid cooling of the silicon melt and is performed to facilitate control of the surface shape of a silicon substrate manufactured through surface flattening.

The inert gas may be blown at a rate of 0.1~2.5 Nm³/h, but is not limited thereto. The blowing rate of inert gas may be changed depending on the position and shape of the silicon substrate forming unit 150.

When using the apparatus shown in Fig. 1, productivity and quality of the manufactured silicon substrate may be significantly affected by process variables, such as the surface temperature of the molten silicon, the preheating temperature of the transfer board, and the moving speed of the transfer board. These process variables affect productivity of the silicon substrate through combinational influence rather than individual influence.

Thus, the process variables according to the present invention are adjusted such that the surface temperature of the molten silicon is in the range of 1300~1500°C, the preheating temperature of the transfer board 140 is in the range of 700~1400°C, and the moving speed of the transfer board 140 is in the range of 300~1400 cm/min. Further, the transfer time of the silicon substrate after tapping the molten silicon from the molten silicon storage unit may be in the range of 0.5∼3.5 seconds.

If the surface temperature of the molten silicon stored in the molten silicon storage unit 130 is less than 1300°C, the molten silicon can solidify before tapping. If the surface temperature of the molten silicon exceeds 1500°C, the silicon melt can trickle down during transfer of the tapped silicon melt.

Further, if the preheating temperature of the transfer board 140 is less than 700°C, the molten silicon can solidify at a contact portion between the transfer board 140 and the molten silicon. On the contrary, if the preheating temperature of the transfer board 140 exceeds 1400°C, the silicon melt can trickle down.

Further, if the moving speed of the transfer board 140 is less than 300 cm/min, the manufactured silicon substrate can be excessively thickened. On the contrary, if the moving speed of the transfer board 140 exceeds 1400 cm/min, the manufactured silicon substrate can be excessively thinned.

Further, if the transfer time of the silicon substrate after tapping the molten silicon from the molten silicon storage unit is less than 0.5 seconds, the manufactured silicon substrate can be excessively thinned. On the contrary, if the transfer time of the silicon substrate after tapping exceeds 3.5 seconds, the silicon substrate can be excessively thickened, thereby making it impossible to perform continuous casting.

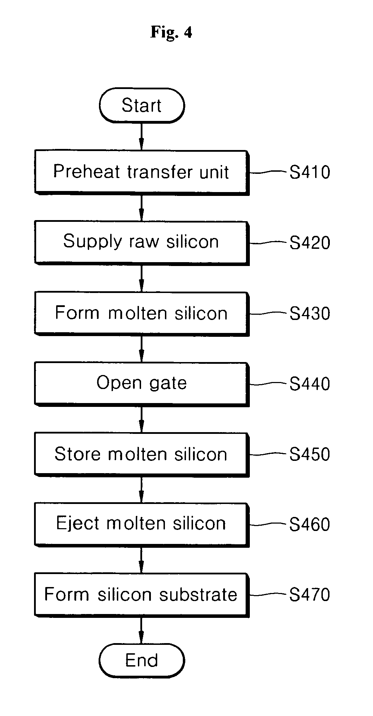

Fig. 4 is a flowchart of a method of manufacturing a silicon substrate using continuous casting according to one exemplary embodiment of the present invention.

Referring to Fig. 4, the silicon substrate manufacturing method using continuous casting includes preheating a transfer board in S410, supplying raw silicon in S420, forming molten silicon in S430, opening a gate in S440, storing the molten silicon in S450, ejecting the molten silicon in S460, and forming a silicon substrate in S470.

In operation S410 of preheating the transfer board, the transfer board disposed at one side of a lower portion of a molten silicon storage unit is preheated. Here, the preheating temperature of the transfer board may be in the range of 700~1400°C. If the preheating temperature of the transfer board is less than 700°C, the molten silicon can be solidified at a contact portion between the transfer board 140 and the molten silicon. On the contrary, if the preheating temperature of the transfer board 140 exceeds 1400°C, the silicon melt can trickle down.

The transfer board may be made of a material that has good wettability, high corrosion resistance and a higher melting point than that of silicon. Further, in order to guarantee easy separation of the silicon substrate after cooling, the transfer board may be made of a material having a different coefficient of thermal expansion than silicon. Specifically, the transfer board may be made of at least one material selected from C, SiC, Si₃N₄, graphite, Al₂O₃ and Mo.

Operation S410 of preheating the transfer board may be performed before operation S440 of opening the gate or operation S450 of storing the molten silicon. In the method according to this embodiment, preheating of the transfer board is not necessarily performed at an initial stage of the method and may be performed by various selective methods as needed.

In operation S420 of supplying raw silicon, a predetermined amount of raw silicon is supplied into a silicon melting unit through a raw silicon feeder.

In operation S430 of forming molten silicon, the raw silicon placed in the silicon melting unit is melted to form molten silicon. The raw silicon may be melted through induction melting. In this case, the silicon melting unit may include a crucible that receives the raw silicon and has a tapping hole formed at a lower side thereof, an induction coil wound around an outer wall of the crucible, and a gate opening or closing the tapping hole.

The crucible may be a graphite crucible. In this case, as shown in Fig. 2, the graphite crucible may have a cylindrical structure in which a plurality of slits is formed to penetrate an outer wall and an inner wall thereof. Further, the graphite crucible may further include a plurality of longitudinal slits formed from an edge of the inner bottom surface of the crucible towards the center of the crucible, as shown in Fig. 3.

In operation S440 of opening a gate, the gate formed at the lower side of the crucible is opened to tap the molten silicon from the silicon melting unit.

In operation S450 of storing the molten silicon, the molten silicon tapped from the silicon melting unit is stored. In the molten silicon storage unit, the surface temperature of the molten silicon may be kept in the range of 1300~1500°C. If the surface temperature of the molten silicon stored in the molten silicon storage unit is less than 1300°C, the molten silicon can solidify before tapping. If the surface temperature of the molten silicon exceeds 1500°C, the silicon melt can trickle down during transfer of the tapped silicon melt.

In operation S460 of ejecting the molten silicon, the transfer board is driven in the horizontal direction to eject the molten silicon.

At this time, the moving speed of the transfer board may be in the range of 300~1400 cm/min, and the transfer time of the silicon substrate after tapping the molten silicon from the molten silicon storage unit may be in the range of 0.5~3.5 seconds.

If the moving speed of the transfer board is less than 300 cm/min, the manufactured silicon substrate can be excessively thickened. If the moving speed of the transfer board exceeds 1400 cm/min, the silicon substrate can be excessively thinned.

Further, if the transfer time of the silicon substrate after tapping the molten silicon from the molten silicon storage unit is less than 0.5 seconds, the manufactured silicon substrate can be excessively thinned. If the transfer time of the silicon substrate after tapping exceeds 3.5 seconds, the silicon substrate can be excessively thickened, thereby making it impossible to perform continuous casting.

In operation S470 of forming a silicon substrate, the silicon melt transferred by the transfer board is cooled to form the silicon substrate.

At this time, cooling the silicon melt may be performed by inert gas blowing, and the inert gas may be argon, without being limited thereto. Alternatively, the inert gas blowing may be performed using helium, nitrogen, and the like. Here, the inert gas may be blown at a rate of 0.1~2.5 Nm³/h, but is not limited thereto.

In this manner, the method of manufacturing a silicon substrate using continuous casting according to the embodiment of the invention can be completed.

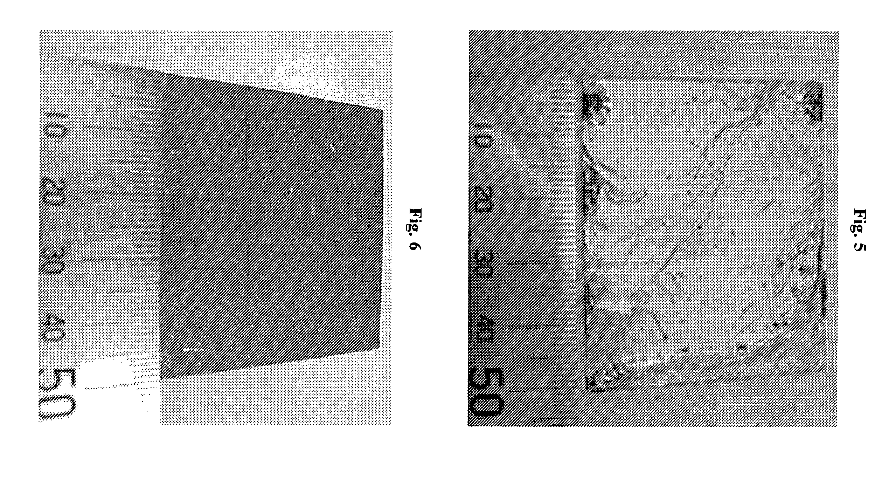

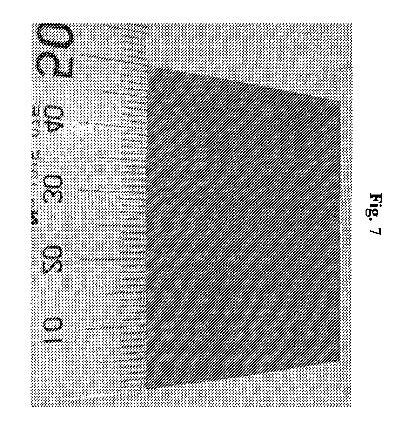

Figs. 5 and 6 are pictures showing a surface and a bottom surface of a silicon substrate manufactured by the method of Fig. 4, in which the silicon substrate has a size of 50 x 50 mm and a thickness of about 360 µm. Fig. 7 is a picture showing a polished surface of the silicon substrate of Fig. 5.

When the silicon melt is not subjected to inert gas blowing, the silicon substrate has a rough surface. Silicon has a melt density of about 2.57 g/cm³ and a solid density of about 2.33 g/cm³. Since the solid density of silicon is lower than the melt density, silicon undergoes expansion during solidification and can have a rough surface in the case where the silicon undergoes non-uniform expansion. As a result, the manufactured silicon substrate has low surface quality.

As shown in Fig. 5, however, when the silicon melt is subjected to inert gas blowing, specifically, argon gas blowing, the manufactured silicon substrate has excellent surface qualities. Here, since the manufactured silicon substrate in Fig. 5 has high surface roughness, the silicon substrate may be subjected to surface polishing, as shown in Fig. 7, in order to use the silicon substrate for solar cells.

The substrate for solar cells typically has a thickness of 100∼400 µm. Thus, when the silicon substrate manufactured by the method shown in Fig. 4 is adjusted to have a thickness of 100∼400 µm, the silicon substrate may be used for solar cells.

As such, the apparatus and method according to the embodiments of the invention may prevent Kerf-loss using continuous casting which facilitates improvement in productivity and property control, thereby improving productivity of the silicon substrate.

Further, the apparatus and method according to the embodiments may optimize process variables and employ inert gas blowing to improve properties of a silicon substrate manufactured thereby.

Accordingly, the silicon substrate manufactured using the apparatus and method according to the embodiments may be applied to a substrate for solar cells.

### Examples

Next, the present invention will be described in detail with reference to illustrative examples. However, it should be understood that the present invention is not limited to the following examples. A description of details apparent to a person having ordinary knowledge in the art will be omitted.

Table 1 shows the thicknesses and shape of silicon substrates prepared by conditions of Examples 1 to 13 and Comparative Examples 1 to 3.

**Table 1**

| | Preheating temperature (°C) | Moving speed (cm/min) | Transfer time after tapping (second) | Substrate thickness (µm) | Substrate shape |
|---|---|---|---|---|---|
| Example 1 | 700 | 485 | 2 5 | 327 | Good |
| Example 2 | 800 | 485 | 2 5 | 296 | Good |
| Example 3 | 900 | 485 | 2 5 | 284 | Good |
| Example 4 | 900 | 485 | 2 5 | 278 | Good |
| Example 5 | 1,000 | 315 | 2 5 | 753 | Bad |
| Example 6 | 1,000 | 485 | 2 5 | 278 | Good |
| Example 7 | 1,000 | 682 | 2 5 | 210 | Good |
| Example 8 | 1,000 | 926 | 2 5 | 145 | Good |
| Example 9 | 1,000 | 485 | 0 5 | 150 | Good |
| Example 10 | 1,000 | 485 | 1 0 | 200 | Good |
| Example 11 | 1,000 | 485 | 1 5 | 208 | Good |
| Example 12 | 1,000 | 485 | 2 0 | 252 | Good |
| Example 13 | 1,000 | 485 | 2 5 | 278 | Good |
| Comparative example 1 | 600 | 485 | 2 5 | - | Bad |
| Comparative example 2 | 1,000 | 1,800 | 2 5 | - | Bad |
| Comparative example 3 | 1,000 | 485 | 4 0 | - | Bad |

Referring to Table 1, Examples 1 to 4 were prepared to determine a relationship between the thickness and shape of the manufactured substrate and the preheating temperature of the transfer board. In Examples 1 to 4, it was ascertained that the thickness of the substrate decreased with increasing preheating temperature of the transfer board. Here, the substrates had good shapes in these inventive examples.

Examples 5 to 8 were prepared to determine a relationship between the thickness and shape of the manufactured substrate and the moving speed of the transfer board. In Examples 5 to 8, it was ascertained that the thickness of the substrate decreases with increasing moving speed of the transfer board. In these examples, the substrates also had good shapes. In Example 5 wherein the moving speed of the transfer board was set to 315 cm/min, it was ascertained that the substrate become excessively thick and was not suited for solar cells. However, it was also ascertained from Example 5 that the substrate could be manufactured to have a suitable thickness for solar cells by adjusting the preheating temperature of the transfer board or the transfer time of the substrate after tapping.

Further, Examples 9 to 13 were prepared to find a relationship between the thickness and shape of the substrate and the transfer time of the substrate after tapping before movement of the transfer board. From these examples, it was ascertained that the thickness of the substrate increased with increasing transfer time of the substrate.

On the contrary, when the preheating temperature of the transfer board was less than 700°C as in Comparative example 1, it was ascertained that the thickness of the substrate remarkably increased due to rapid solidification, so that the substrate was trapped by the ejection port, thereby making it impossible to perform continuous casting. However, it was also ascertained from Comparative Example 1 that the substrate could be manufactured to have a suitable thickness for solar cells by adjusting the moving speed of the transfer board or the transfer time of the substrate after tapping.

Further, when the transfer board was moved at a very high speed of 1,800 cm/min as in Comparative example 2, it was ascertained that pores were created in the substrate, causing deterioration in reliability of the substrate. However, it was also ascertained from Comparative Example 2 that the substrate could be manufactured to have a suitable thickness for solar cells by adjusting the moving speed of the transfer board or the transfer time of the substrate after tapping.

In addition, when the transfer time of the substrate after tapping was 4 seconds as in Comparative example 3, it was ascertained that the manufactured substrate become excessively thick, thereby making it impossible to perform continuous casting. However, it was also ascertained from Comparative Example 3 that the substrate could be manufactured to have a suitable thickness for solar cells by adjusting the moving speed of the transfer board or the transfer time of the substrate after tapping. As such, even when manufacture of a desired silicon substrate becomes difficult due to a specific process variable, it is possible to manufacture a silicon substrate having good quality by controlling other process variables.

Although some embodiments have been described herein, it should be understood by those skilled in the art that these embodiments are given by way of illustration only, and that various modifications, variations, and alterations can be made without departing from the scope of the invention. Therefore, the scope of the invention should be limited only by the accompanying claims.

## Claims

1. An apparatus (100) for manufacturing a silicon substrate using continuous casting, the apparatus comprising:
a raw silicon feeder (110) through which raw silicon is fed;
a silicon melting unit (120) disposed under the raw silicon feeder (110) and for melting the raw silicon to form molten silicon;
a molten silicon storage unit (130) for storing the molten silicon supplied from the silicon melting unit (120) and for tapping the molten silicon to provide a silicon melt having a constant thickness;
a transfer board (140) disposed at one side of the molten silicon storage unit (130) and for transferring the tapped silicon melt; and
a silicon substrate forming unit (150) for cooling the silicon melt transferred by the transfer board (140) to form a silicon substrate,
wherein the silicon melting unit (120) comprises a crucible (121) for receiving the raw silicon supplied from the raw silicon feeder (110) and having a tapping hole (123) formed at a lower side thereof, an induction coil (122) wound around an outer wall of the crucible (121), and a gate (124) opening or closing the tapping hole (123), and
wherein the crucible (121) is a graphite crucible including a plurality of first slits (230) longitudinally formed on a part of a wall of the crucible or a plurality of second slits (310) longitudinally formed on a part of a bottom surface of the crucible (121).

2. The apparatus (100) of claim 1, wherein the molten silicon storage unit (130) is formed at one side thereof with an ejection port (132) through which the molten silicon is ejected.

3. The apparatus (100) of claim 2, wherein the ejection port (132) has a thickness of 0.1~2 mm.

4. The apparatus (100) of claim 1, wherein the transfer board (140) is made of at least one selected from C, SiC, Si₃N₄, graphite, AlO₃ and Mo.

5. The apparatus (100) of claim 1, wherein the silicon substrate forming unit (150) cools the transferred silicon melt by inert gas blowing.

6. A method of manufacturing a silicon substrate using the apparatus (100) of claim 1, the method comprising:
supplying (S420) raw silicon into the silicon melting unit (120);
melting (S430) the raw silicon placed in the silicon melting unit (120) to form molten silicon;
opening (S440) the gate (124) of the silicon melting unit (120) to tap the molten silicon;
storing (S450) the tapped molten silicon in the molten silicon storage unit (130);
driving the transfer board (140) to transfer the molten silicon; and
cooling (S470) the molten silicon transferred by the transfer board (140) to form a silicon substrate,
preheating (S410) the transfer board (140) to 700~1400 °C before supplying the raw silicon into the silicon melting unit (120),
wherein the molten silicon is kept at a surface temperature of 1300~1500 °C in the molten silicon storage unit (120), and
wherein, when driving the transfer board (140) to transfer the molten silicon, the transfer board (140) is moved at a speed of 300~1400 cm/min.

7. The method of claim 6, wherein the transfer board (140) is made of at least one selected from C, SiC, Si₃N₄, graphite, Al₂O₃ and Mo.

8. The method of claim 6, wherein the silicon melt is cooled by blowing inert gas to the silicon melt transferred by the transfer board (140).

9. A silicon substrate for solar cells manufactured by the method of claim 6, the silicon substrate having a thickness of 100~400 µm.

## Patentansprüche

1. Vorrichtung (100) zur Herstellung eines Siliziumsubstrats unter Verwendung von Stranggießen, wobei die Vorrichtung umfasst:
einen Rohsiliziumzubringer (110), über den das Rohsilizium eingespeist wird;
eine Siliziumschmelzeinheit (120), die unter dem Rohsiliziumzubringer (110) angeordnet ist, zum Schmelzen des Rohsiliziums unter Ausbildung von geschmolzenem Silizium;
eine Siliziumschmelze-Speichereinheit (130) zum Speichern des von der Siliziumschmelzeinheit (120) bereitgestellten geschmolzenen Siliziums und zum Abstechen des geschmolzenen Siliziums zum Bereitstellen einer Siliziumschmelze mit einer konstanten Dicke;
eine Transportplatte (140), die an einer Seite der Siliziumschmelze-Speichereinheit (130) angeordnet ist, zum Transport der abgestochenen Siliziumschmelze; und
eine Siliziumsubstrat-Formeinheit (150) zum Abkühlen der von der Transportplatte (140) transportierten Siliziumschmelze unter Ausbildung eines Siliziumsubstrats,
wobei die Siliziumschmelzeinheit (120) einen Tiegel (121) zur Aufnahme des von dem Rohsiliziumzubringer (110) bereitgestellten Rohsiliziums und mit einer an der unteren Seite davon ausgebildeten Abstichöffnung (123), eine um eine Außenwand des Tiegels (121) gewickelte Induktionsspule (122) und eine die Abstichöffnung (123) öffnende und schließende Klappe (124) umfasst, und
wobei der Tiegel (121) ein Grafiktiegel mit einer Mehrzahl erster in Längsrichtung an einem Teil einer Wand des Tiegels ausgebildeter Schlitze (230) oder einer Mehrzahl zweiter in Längsrichtung an einem Teil einer Bodenfläche des Tiegels (121) ausgebildeter Schlitze (310) ist.

2. Vorrichtung (100) nach Anspruch 1, wobei die Siliziumschmelze-Speichereinheit (130) an einer Seite davon mit einem Ausstoßauslass (132) ausgebildet ist, durch den das geschmolzene Silizium ausgestoßen wird.

3. Vorrichtung (100) nach Anspruch 2, wobei der Ausstoßauslass (132) eine Dicke von 0,1~2 mm aufweist.

4. Vorrichtung (100) nach Anspruch 1, wobei die Transportplatte (140) aus mindestens einem Material hergestellt ist, ausgewählt aus C, SiC, Si₃N₄, Grafit, Al₂O₃ und Mo.

5. Vorrichtung (100) nach Anspruch 1, wobei die Siliziumsubstrat-Formeinheit (150) die transportierte Siliziumschmelze durch Einblasen eines inerten Gases abkühlt.

6. Verfahren zur Herstellung eines Siliziumsubstrats unter Verwendung der Vorrichtung (100) nach Anspruchl, wobei das Verfahren umfasst:
Bereitstellen (S420) von Rohsilizium in der Siliziumschmelzeinheit (120);
Schmelzen (S430) des sich in der Schmelzeinheit (120) befindenden Rohsiliziums unter Ausbildung von geschmolzenem Silizium;
Öffnen (S440) der Klappe (124) der Siliziumschmelzeinheit (120) zum Abstechen des geschmolzenen Siliziums;
Speichern (S450) des abgestochenen geschmolzenen Siliziums in der Siliziumschmelze-Speichereinheit (130);
Antreiben der Transportplatte (140) zum Transportieren des geschmolzenen Siliziums; und
Abkühlen (S470) des von der Transportplatte (140) transportierten geschmolzenen Siliziums unter Ausbildung eines Siliziumsubstrats,
Vorwärmen (S410) der Transportplatte (140) auf 700~1400 °C vor dem Bereitstellen des Rohsiliziums in der Siliziumschmelzeinheit (120),
wobei die Oberflächentemperatur des geschmolzenen Siliziums in der Siliziumschmelze-Speichereinheit (120) auf 1300~1500 °C gehalten wird, und
wobei die Transportplatte (140) beim Antrieb der Transportplatte (140) zum Transport des geschmolzenen Siliziums mit einer Geschwindigkeit von 300~1400 cm/min bewegt wird.

7. Verfahren nach Anspruch 6, wobei die Transportplatte (140) aus mindestens einem Material hergestellt ist, ausgewählt aus C, SiC, Si₃N₄, Grafit, Al₂O₃ und Mo.

8. Verfahren nach Anspruch 6, wobei die Siliziumschmelze durch Einblasen von inertem Gas auf die von der Transportplatte (140) transportierte Siliziumschmelze abgekühlt wird.

9. Siliziumsubstrat für Solarzellen, hergestellt mittels des Verfahrens nach Anspruch 6, wobei das Siliziumsubstrat eine Dicke von 100~400 µm aufweist.

## Revendications

1. Appareil (100) de fabrication d'un substrat en silicium par moulage continu, l'appareil comprenant :
un système d'alimentation en silicium brut (110) assurant l'alimentation en silicium brut ;
une unité de fusion de silicium (120) disposée sous le système d'alimentation en silicium brut (110) et pour fondre le silicium brut pour former du silicium en fusion ;
une unité de stockage de silicium en fusion (130) pour stocker le silicium en fusion provenant de l'unité de fusion de silicium (120) et pour couler le silicium en fusion pour produire une masse fondue de silicium d'épaisseur constante ;
une plaque de transfert (140) disposée au niveau d'un côté de l'unité de stockage de silicium en fusion (130) et pour transférer la masse fondue de silicium coulée ; et
une unité de mise en forme du substrat en silicium (150) pour refroidir la masse fondue de silicium transférée par la plaque de transfert (140) pour former un substrat en silicium,
dans lequel l'unité de fusion de silicium (120) comprend un creuset (121) pour recevoir le silicium brut provenant du système d'alimentation en silicium brut (110) et possédant un trou de coulée (123) formé au niveau d'un côté inférieur de celui-ci, une bobine d'induction (122) enroulée autour d'une paroi extérieure du creuset (121), et un obturateur (124) ouvrant ou fermant le trou de coulée (123), et
dans lequel le creuset (121) est un creuset en graphite comprenant plusieurs premières fentes (230) formées longitudinalement sur une partie d'une paroi du creuset ou plusieurs deuxièmes fentes (310) formées longitudinalement sur une partie d'une surface inférieure du creuset (121).

2. L'appareil (100) de la revendication 1, dans lequel l'unité de stockage de silicium en fusion (130) est formée au niveau d'un côté de celui-ci avec un orifice d'éjection (132) par lequel le silicium en fusion est éjecté.

3. L'appareil (100) de la revendication 2, dans lequel l'orifice d'éjection (132) présente une épaisseur de 0,1~2 mm.

4. L'appareil (100) de la revendication 1, dans lequel la plaque de transfert (140) est constituée d'au moins un matériau choisi parmi C, SiC, Si₃N₄, graphite, Al₂O₃ et Mo.

5. L'appareil (100) de la revendication 1, dans lequel l'unité de mise en forme du substrat en silicium (150) refroidit la masse fondue de silicium transférée par soufflage de gaz inerte.

6. Procédé de fabrication d'un substrat en silicium utilisant l'appareil (100) de la revendication 1, le procédé comprenant :
l'apport (S420) de silicium brut dans l'unité de fusion de silicium (120) ;
la fusion (S430) du silicium brut placé dans l'unité de fusion de silicium (120) pour former du silicium en fusion ;
l'ouverture (S440) de l'obturateur (124) de l'unité de fusion de silicium (120) pour couler le silicium en fusion ;
le stockage (S450) du silicium en fusion coulé dans l'unité de stockage de silicium en fusion (130) ;
l'actionnement de la plaque de transfert (140) pour transférer le silicium en fusion ; et
le refroidissement (S470) du silicium en fusion transféré par la plaque de transfert (140) pour former un substrat en silicium,
le préchauffage (S410) de la plaque de transfert (140) à 700~1400 °C avant de faire passer le silicium brut dans l'unité de fusion de silicium (120),
dans lequel le silicium en fusion est maintenu à une température de surface de 1300~1500 °C dans l'unité de stockage de silicium en fusion (120), et
dans lequel, lors de l'actionnement de la plaque de transfert (140) pour transférer le silicium en fusion, la plaque de transfert (140) est déplacée à une vitesse de 300~1400 cm/mn.

7. Le procédé de la revendication 6, dans lequel la plaque de transfert (140) est constituée d'au moins un matériau choisi parmi C, SiC, Si₃N₄, graphite, Al₂O₃ et Mo.

8. Le procédé de la revendication 6, dans lequel la masse fondue de silicium est refroidie par soufflage de gaz inerte sur la masse fondue de silicium transférée par la plaque de transfert (140).

9. Substrat en silicium pour cellules solaires fabriqué par le procédé de la revendication 6, le substrat en silicium présentant une épaisseur de 100~400 µm.
